(19)

**Europäisches Patentamt**
**European Patent Office**
**Office européen des brevets**

(11)  **EP 1 362 412 B1**

(12)  # EUROPEAN PATENT SPECIFICATION

(45) Date of publication and mention
of the grant of the patent:
**17.04.2013 Bulletin 2013/16**

(21) Application number: **01981455.7**

(22) Date of filing: **09.10.2001**

(51) Int Cl.:
*H03B 21/01* (2006.01)    *H03D 7/16* (2006.01)

(86) International application number:
**PCT/US2001/031695**

(87) International publication number:
**WO 2002/031962 (18.04.2002 Gazette 2002/16)**

(54) **QUADRATURE FREQUENCY CONVERTER**

QUADRATUR FREQUENZUMSETZER

PROCEDE ET CIRCUIT POUVANT PRODUIRE DES SINUSOIDES DESTINEES A DES
MODULATEURS ET DES CONVERTISSEURS DE FREQUENCE

(84) Designated Contracting States:
**AT BE CH CY DE DK ES FI FR GB GR IE IT LI LU
MC NL PT SE TR**

(30) Priority: **10.10.2000 US 686267**

(43) Date of publication of application:
**19.11.2003 Bulletin 2003/47**

(73) Proprietor: **QUALCOMM INCORPORATED**
**San Diego, CA 92121-1714 (US)**

(72) Inventors:
• **SAHOTA, Gurkanwal, S.**
**San Diego, CA 92103 (US)**

• **GARD, Kevin**
**San Diego, CA 92128 (US)**

(74) Representative: **Reedy, Orlaith et al**
**Tomkins & Co**
**5 Dartmouth Road**
**Dublin 6 (IE)**

(56) References cited:
**EP-A- 0 903 846    US-A- 5 412 351**
**US-A- 5 942 929    US-A- 6 029 059**

• **PATENT ABSTRACTS OF JAPAN vol. 1997, no.
02, 28 February 1997 (1997-02-28) & JP 08 256187
A (FUJITSU LTD;FUJITSU VLSI LTD), 1 October
1996 (1996-10-01)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**BACKGROUND OF THE INVENTION**

**I. Field of the Invention**

The present invention relates to communications systems. More particularly, the present invention relates to novel and improved techniques for generating sinusoids used for modulation and frequency conversion of analog signals.

**II. Description of the Related Art**

In many modem communications systems, digital transmission is utilized because of improved efficiency and enhanced performance. Examples of digital transmission formats include binary phase shift keying (BPSK), quaternary phase shift keying (QPSK), offset quaternary phase shift keying (OQPSK), m-ary phase shift keying (m-PSK), and quadrature amplitude modulation (QAM). Examples of communications systems that utilize digital transmission include code division multiple access (CDMA) communications systems and high definition television (HDTV) systems.

In typical digital communications systems, the signal to be transmitted is initially generated and processed at baseband. The baseband processing can include buffering, filtering, and amplification. The processed baseband signal is then modulated to an intermediate frequency (IF). Additional signal processing (i.e., buffering, filtering, amplification, and so on) is then performed on the modulated IF signal. The modulated and processed IF signal is upconverted to radio frequency (RF), further processed, and transmitted.

At a receiver, the transmitted RF signal is received, processed (i.e., amplified and filtered), and downconverted to an IF frequency (that may or may not match the IF frequency at the transmitter). The IF signal is then demodulated using a demodulation scheme complementary to the modulation scheme used at the transmitter.

In many conventional transmitter and receiver architectures, the signal processing includes two frequency conversion steps. One frequency conversion step results from the modulation of the data (or the demodulation of the received signal). The other frequency conversion step performs a frequency translation from an initial frequency to a final frequency. For a transmitter, the first conversion step generates the modulated IF signal and the second conversion step generates the upconverted RF signal. And for a receiver, the first conversion step generates the downconverted IF signal and the second conversion step generates the demodulated baseband signal.

The IF frequency is typically selected based on various considerations including ease of circuit design and ease of filtering of spurious signals. For example, the phase splitter to generate the inphase and quadrature sinusoids can often be more easily designed and manufactured to meet the required specifications at the IF frequency. The RF frequency is also selected based on a number of considerations such as ease of signal transmission and conformance to industry standards. Dual frequency conversion designs offer flexibility in frequency planning, ease of signal filtering, high isolation, allowance for wide variable gain range, and other advantages. These advantages are generally obtained at the expense of additional circuitry and power consumption.

Direct upconversion transmitter architectures generate modulated RF signals directly from baseband signals using a single modulation/ frequency conversion step. Direct conversion architectures generally require less circuitry to implement, which often translates to simplified and power efficient designs. However, direct conversion transmitter architectures typically encounter various implementation difficulties. For example, it is generally not practical to use a voltage control oscillator (VCO) to generate a RF sinusoid (RF LO) at the same frequency as that of the modulated RF signal. The VCO invariably exhibits some amount of "leakage" to the RF signal, and this leakage can degrade system performance if the VCO is operated at the same frequency as the RF signal. Moreover, in the transmitter, the large amplitude of the RF signal can also "pull" on the VCO and adversely affect its performance. VCO pulling causes additional phase noise in the RF sinusoid, which can result in performance degradation.

Direction upconversion using a RF sinusoid generated from two intermediate sinusoids ameliorates some of the performance degradations described above (i.e., the LO leakage and VCO pulling). A circuit that generates the RF LO in such manner is described in U.S. Patent No. 5,412,351, entitled "Quadrature Local Oscillator Network". This LO generation circuit includes four mixers, two phase splitters, and two summers. The mixers are operated at RF frequency and are biased with high currents to provide the required linearity and bandwidth. The mixers also generate spurious signals that can degrade the performance of the transmitter.

Accordingly, techniques to generate sinusoids using less circuitry and having robust performance are highly desirable.

United States Patent No. 6 029 059 describes a quadrature mixer method and apparatus.

## SUMMARY OF THE INVENTION

The present invention as set art in the appended claims provides techniques to generate sinusoids that can be used for modulation and/or frequency conversion. For improved RF performance, the sinusoids are generated from two intermediate sinusoids, e.g., an IF sinusoid and a RF sinusoid. The techniques of the invention require fewer number of mixers than conventional techniques, which can translate to reduced circuit complexity, lower power consumption, and other advantages.

The invention provides a signal generator according to independent claims 1 and 9.

A third phase shift network can receive a first input sinusoid at the first frequency and generate the inphase and quadrature sinusoids.

The signal generator can be advantageously implemented using Gilbert cell multipliers for the mixers and polyphase filters for the phase shift networks. The summer can be implemented by coupling the proper current signals from the phase shift networks. A stacked circuit topology can be used to reduce power consumption. The signal generator can be used in a transmitter (e. g., for modulation or upconversion, or both) or in a receiver (e. g., for demodulation or downconversion, or both). The signal generator can be specifically designed for used in a cellular (e. g., CDMA) telephone.

The invention provides also a method for generating local oscillator sinusoids according to independent claims 8 and 10.

A first input sinusoid at the first frequency can be phase shifted to generate the first inphase and quadrature sinusoids.

Yet another embodiment of the invention provides a modulator that includes a direct upconverter coupled to a sinusoid generator. The direct upconverter receive and mix at least one analog signal and at least one upconvert sinusoid to provide a modulated signal. The sinusoid generator couples to the direct upconverter and is implemented in the manner described above. The modulator can be used, for example, in a cellular telephone.

## BRIEF DESCRIPTION OF THE DRAWINGS

The features, nature, and advantages of the present invention will become more apparent from the detailed description set forth below when taken in conjunction with the drawings in which like reference characters identify correspondingly throughout and wherein:

FIG. 1 shows a simplified block diagram of an example of a transmitter that performs quadrature modulation using two frequency conversion stages;
FIG. 2 shows a simplified block diagram of an embodiment of a transmitter that performs direct quadrature modulation using a single frequency conversion stage;
FIG. 3 shows a block diagram of a conventional LO generator;
FIG. 4 shows a block diagram of an embodiment of a LO generator of the invention;
FIG. 5 shows a block diagram of a specific implementation of the LO generator of FIG. 4;
FIGS. 6A and 6B show block diagrams of specific embodiments of a single-pole and a three-pole phase shift network, respectively;
FIGS. 6C and 6D show the phase and amplitude responses, respectively, of the three-pole phase shift network; and
FIG. 7 shows a block diagram of a specific embodiment of a direct upconverter.

## DETAILED DESCRIPTION OF THE SPECIFIC EMBODIMENT

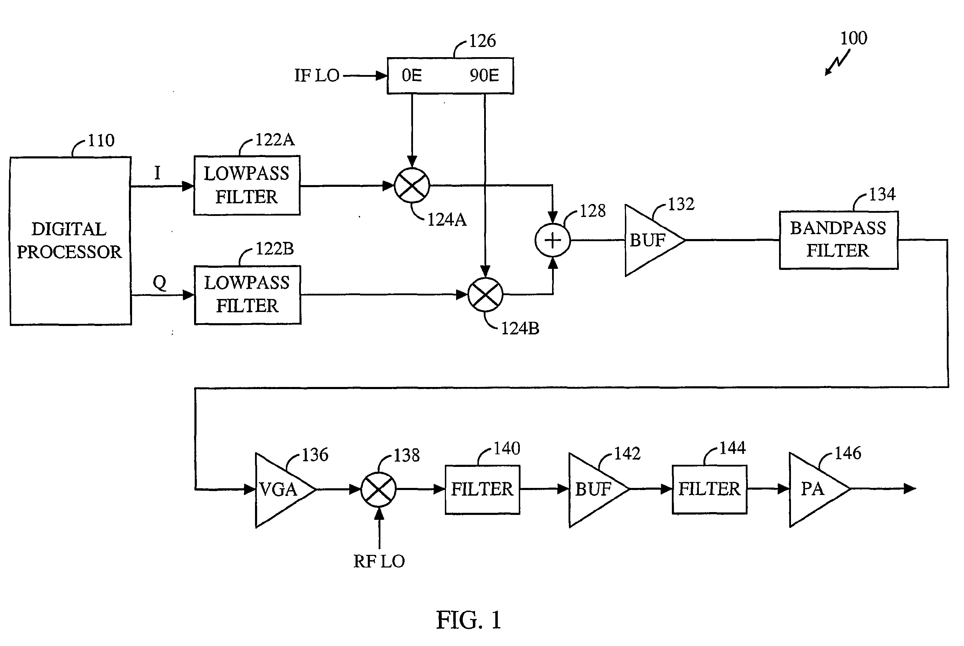

FIG. 1 shows a simplified block diagram of an example of a transmitter 100 that performs quadrature phase shift keying (QPSK) modulation using two frequency conversion stages. A digital processor 110 generates data, encodes and modulates the data, and converts the digitally processed data into an inphase (I) signal and a quadrature (Q) signal. The baseband I and Q signals are provided to a pair of lowpass filters 122a and 122b, respectively, that perform (i.e., match) filtering of the baseband signals. The filtered I and Q signals are provided to a pair of mixers 124a and 124b, respectively, that modulate the signals to an intermediate frequency (IF) with an inphase IF sinusoid (or LO) and a quadrature IF LO, respectively, received from an IF phase splitter 126. The IF outputs from mixers 124a and 124b are summed together by a summer 128 to generate a modulated IF signal. The IF signal is provided to a buffer 132 that buffers the IF signal and drives a bandpass filter 134. Filter 134 filters the buffered IF signal to remove out-of-band noise and undesired signals.

The filtered IF signal is provided to a variable gain amplifier (VGA) 136 that amplifies the signal with a gain determined by a gain control signal from a gain control circuit (not shown). The amplified IF signal is provided to a mixer 138 that also receives a sinusoid at a radio frequency (RF LO) and upconverts the IF signal with the RF LO to generate an RF signal. The RF signal is provided to a filter 140 that filters images generated by the preceding upconversion stage.

The filtered signal is provided to a buffer 142 that buffers the signal and drives a filter 144. Filter 144 further filters noise from the signal and provides the filtered signal to a power amplifier (PA) 146 that provides the required signal drive. The output of PA 146 couples to an antenna via an isolator and a duplexer (all three elements not shown in FIG. 1). The embodiment shown in FIG. 1 includes a double sideband upconverter with image reject filters. A single sideband upconverter can also be implemented in a manner known in the art.

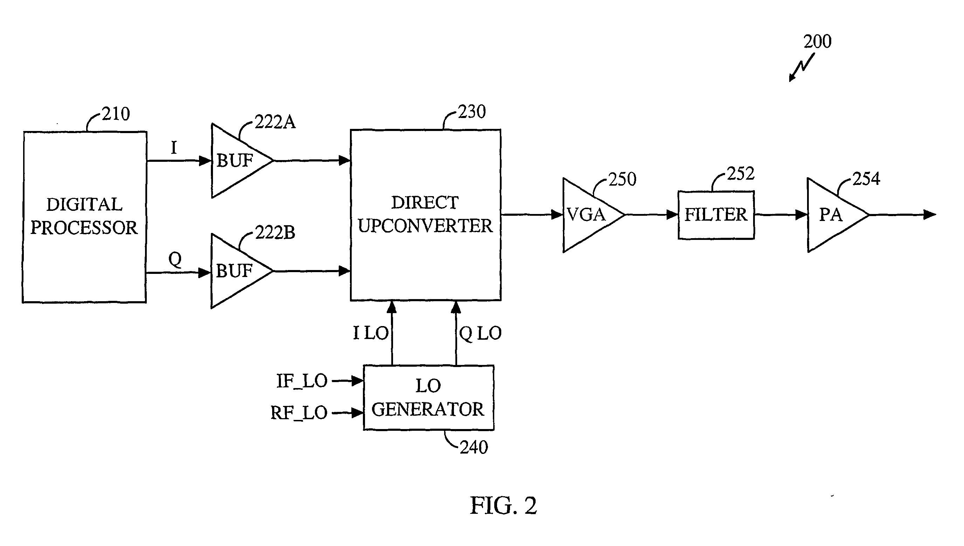

FIG. 2 shows a simplified block diagram of an embodiment of a transmitter 200 that performs direct quadrature modulation using a single frequency conversion stage. A digital processor 210 generates data, encodes and modulates the data, and converts the digitally processed data into an I signal and a Q signal, similar to processor 110 in FIG. 1. The baseband I and Q signals are provided to a pair of buffers 222a and 222b, respectively, that buffer the signals and provide the buffered baseband signals to a direct upconverter 230. Upconverter 230 also receives an inphase LO (I LO) and a quadrature LO (Q LO) from a LO generator 240 and upconverts the baseband signals to RF. In an embodiment, I LO and Q LO are generated from sinusoids at two frequencies (e.g., an IF LO and a RF LO). The RF signal is provided to a VGA 250 that amplifies signal with a gain determined by a gain control signal (not shown). The amplified RF signal is provided to a filter 252 that filters the noise from the signal. The filtered signal is provided to a PA 254 that drives an antenna.

Various modifications can be made to the transmitter embodiment shown in FIG. 2. For example, the transmit signal path may be designed to include fewer or additional buffer and amplifier stages, one or more filters, and other circuits. As an example, a filter may be provided after the direct upconverter to filter out spurious signals. Moreover, the elements within the signal path may be arranged in different configurations. In a specific implementation, the transmit signal path from buffer 222 to PA 254 is implemented within one or more integrated circuits, although discrete elements may also be used.

In one specific transmitter embodiment, quadrature modulation is performed within the digital processor on the baseband I and Q signals. The digitally modulated signal is then directly upconverted to RF by a frequency upconversion stage using the LO generated in accordance with the invention.

Transmitter 200 includes a single frequency conversion stage performed by upconverter 230. Using direct baseband to RF modulation and upconversion, many advantages may be obtained. Some of the advantages are enumerated below.

First, the direct upconversion architecture is typically less complex than the dual upconversion architecture. By eliminating one frequency conversion stage, the number of components in the transmit signal path is correspondingly reduced. For example, the transmitter architecture shown in Fig. 2 does not include some of the buffer, filter, and mixer stages present in the architecture shown in FIG. 1. The reduction in circuit complexity decreases cost and improves reliability.

Second, the direct upconversion architecture (typically) consumes less power than the dual upconversion architecture. This results from the elimination of some stages in the transmit signal path, as noted above, and also from specific implementations of the circuitry within the transmit signal path, as described below. Reduced power consumption is particularly advantageous for some applications such as, for example, a cellular telephone because of its portable nature.

Third, the direct upconversion architecture does not generates IF harmonics and generally produces less spurious signals than the dual upconversion architecture. Typically, mixers are operated as non-linear devices that generate harmonics and mixing products. In the dual upconversion architecture, the IF mixers generate spurious signals that are filtered, to an extent, by the bandpass filter placed after the IF mixers. By eliminating the IF upconversion stage, IF harmonics are not generated and the IF filtering requirement is relaxed.

Fourth, the direct upconversion architecture may be designed to provide improved performance. For example, upconverter 230 may be designed such that the modulated RF signal is more tolerant to phase and amplitude imbalances in the I LO and Q LO.

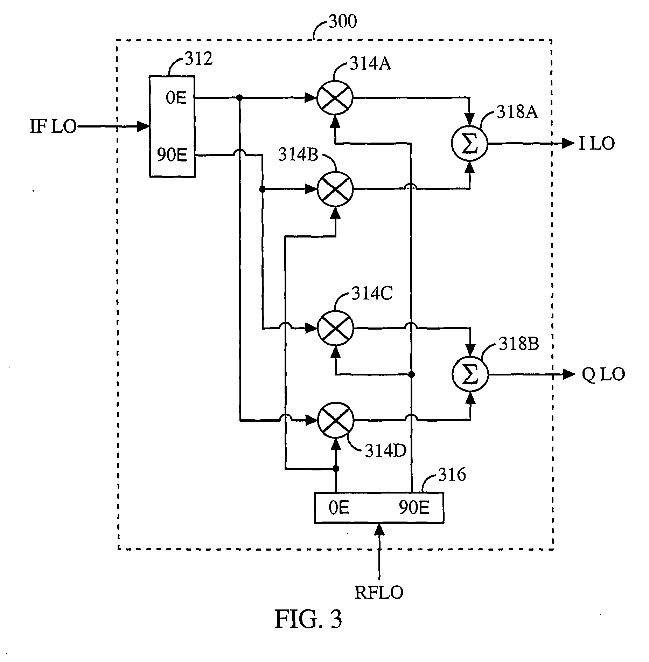

FIG. 3 shows a block diagram of a conventional LO generator 300. Generator 300 generates an inphase sinusoid (I LO) and a quadrature sinusoid (Q LO) at a RF frequency based on an input IF sinusoid (IF LO) and an input RF sinusoid (RF LO). Within generator 300, the IF LO is provided to a phase shift network 312 that provides the inphase (0°) and quadrature (90°) IF sinusoids. The inphase IF sinusoid is provided to mixers 314a and 314d, and the quadrature IF sinusoid is provided to mixers 314b and 314c. Similarly, the RF LO is provided to a phase shift network 316 that provides the inphase and quadrature RF sinusoids. The inphase RF sinusoid is provided to mixers 314b and 314d, and the quadrature RF sinusoid is provided to mixers 314a and 314c. Mixers 314a and 314b mix the two input sinusoids and provide the mixed signals to a summer 318a that combines the signals to provide the I LO. Similarly, mixers 314c and 314d mix the two input sinusoids and provide the mixed signals to a summer 318b that combines the signals to provide the Q LO. The I LO and Q LO are provided to subsequent mixers (not shown in FIG. 3) that directly modulates a baseband signal to RF (i.e., for a transmitter) or directly demodulates a received RF signal to baseband (i.e., for a receiver).

LO generator 300 provides the I LO and Q LO using two sinusoids, which is preferred in some applications.

However, generator 300 exhibits several disadvantages. In particular, generator 300 includes four mixers operated at RF frequency. These mixers have a tendency to generate spurious signals that can cause degradation in the performance of the transmitter or receiver. To reduce the amount of mixing of harmonics, it is preferable to operate the mixers in the linear region. To achieve the required circuit performance (e.g., linearity and bandwidth) at RF frequency, the mixers and subsequent summers are typically biased with high current. For some applications, such as CDMA communications systems, power consumption is an important design parameter and circuits that require high bias currents are typically not preferred.

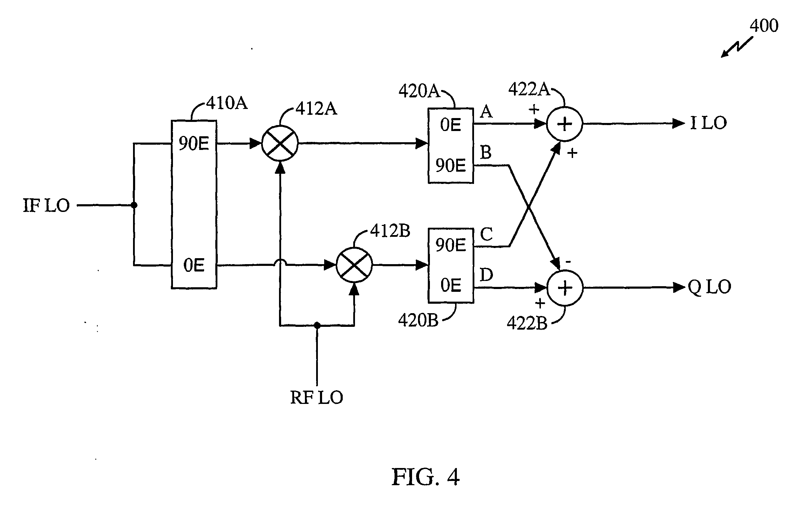

FIG. 4 shows a block diagram of an embodiment of a LO generator 400 of the invention. An IF LO is provided to a phase shift network 410 that provides two sinusoids in quadrature, i.e., one sinusoid having an additional 90 degrees of phase shift relative to the other sinusoid. The inphase and quadrature IF LO from phase shifting circuit 410 are provided to mixers 412b and 412a, respectively. Each mixer 412 also receives the RF LO and mixes the two sinusoids. The output from mixers 412a and 412b are provided to phase shift networks 420a and 420b, respectively. Each phase shift network 420 generates an inphase component and a quadrature component of the input signal. The outputs from phase shift networks 420a and 420b are cross-coupled and provided to summers 422a and 422b. Summer 422a receives and adds the inphase component from phase shift network 420a and the quadrature component from phase shift network 420b to generate the I LO. Summer 422b receives and subtracts the quadrature component from phase shift network 420a from the inphase component from phase shift network 420b to generate the Q LO.

If the RF LO is expressed as $\sin(\omega_{RF})$ and the IF LO is expressed as $\cos(\omega_{IF})$, the components $a$, $b$, $c$, and $d$ from phase shift networks 420a and 420b can be expressed as:

$$a = \cos(\omega_{RF} - \omega_{IF}) - \cos(\omega_{RF} + \omega_{IF}) , \qquad \text{Eq. (1)}$$

$$b = -\sin(\omega_{RF} - \omega_{IF}) + \sin(\omega_{RF} + \omega_{IF}) , \qquad \text{Eq. (2)}$$

$$c = \cos(\omega_{RF} - \omega_{IF}) + \cos(\omega_{RF} + \omega_{IF}) , \text{ and} \qquad \text{Eq. (3)}$$

$$d = \sin(\omega_{RF} - \omega_{IF}) + \sin(\omega_{RF} + \omega_{IF}) . \qquad \text{Eq. (4)}$$

It can be noted that each component ($a$, $b$, $c$, or $d$) includes a sinusoid at the summed frequency ($\omega_{RF} + \omega_{IF}$) and a sinusoid at the difference frequency ($\omega_{RF} - \omega_{IF}$). By properly combining pairs of these components, either the summed frequency sinusoid or the difference frequency sinusoid can be canceled. The remaining (summed or difference) sinusoid can be used for modulation, demodulation, or frequency conversion.

In the specific embodiment shown in FIG. 4, the summed frequency sinusoids are canceled and the difference frequency sinusoids are provided as I LO and Q LO, which can be expressed as:

$$I \ LO = \cos(\omega_{RF} - \omega_{IF}) , \text{ and} \qquad \text{Eq. (5)}$$

$$Q \ LO = \sin(\omega_{RF} - \omega_{IF}) . \qquad \text{Eq. (6)}$$

Alternatively, the difference frequency sinusoids can be canceled and the summed frequency sinusoids can be provided as the I LO and Q LO. The summed frequency sinusoids can be obtained by inverting the signs of components a and b from those shown in FIG. 4.

In a specific implementation particularly applicable to CDMA communications systems, the IF LO has a frequency of approximately 100 to 225 MHz, and the RF LO ranges in frequency from 824 to 849 MHz for the cellular band and 1850 to 1910 MHz for the PCS band. With these frequency selections, the I LO and Q LO can be generated to cover a frequency range of 954 to 979 MHz for the cellular band (i.e., using the summed frequency sinusoids, $\omega_{RF} + \omega_{IF}$) and

a frequency range of 1720 to 1780 MHz for the PCS band (i.e., using the difference frequency sinusoids, $\omega_{RF}$ - $\omega_{IF}$). Alternatively, to cover the same cellular and PCS frequency ranges, the RF LO can range in frequency from 1084 to 1109 MHz for the cellular band (i.e., using the difference frequency sinusoids) and 1590 to 1650 MHz for the PCS band (i.e., using the summed frequency sinusoids).

The generation of the I LO and Q LO using two input sinusoids provides several advantages. First, the frequencies of the input sinusoids are different from that of the modulated RF signal, thus avoiding performance degradation due to LO leakage and VCO pulling. In addition, the VCOs to generate the IF LO and RF LO can be designed to operate at frequencies lower than that of the I LO and Q LO, thus achieving improved phase noise performance for a particular signal level.

LO generator 400 provides many advantages over other conventional LO generators. For example, LO generator 400 includes two less mixers than LO generator 300 shown in Fig. 3. A fewer number of mixers reduces circuit complexity and also generates less spurious signals. LO generator 400 can also be designed to use about half the bias current as LO generator 300, again since it includes half the number of mixers operated in parallel.

The architecture of LO generator 400 also reduces the effect of phase errors introduced by phase shift networks 420a and 420b. In particular, if phase shift network 420a or 420b generates a quadrature signal having a phase of 90° + $\theta_{ERR}$ (where $\theta_{ERR}$ represents the phase error), the phase errors in I LO and Q LO can be shown to be:

$$\theta_{ERR\_OUT} = \tan^{-1}\left(\frac{\sin(\theta_{ERR})}{1+\cos(\theta_{ERR})}\right) \cong \frac{\theta_{ERR}}{2} \quad . \qquad \text{Eq. (7)}$$

Equation (7) indicates that the phase errors in the output signals are approximately half the phase error generated by phase shift networks 420a and 420b.

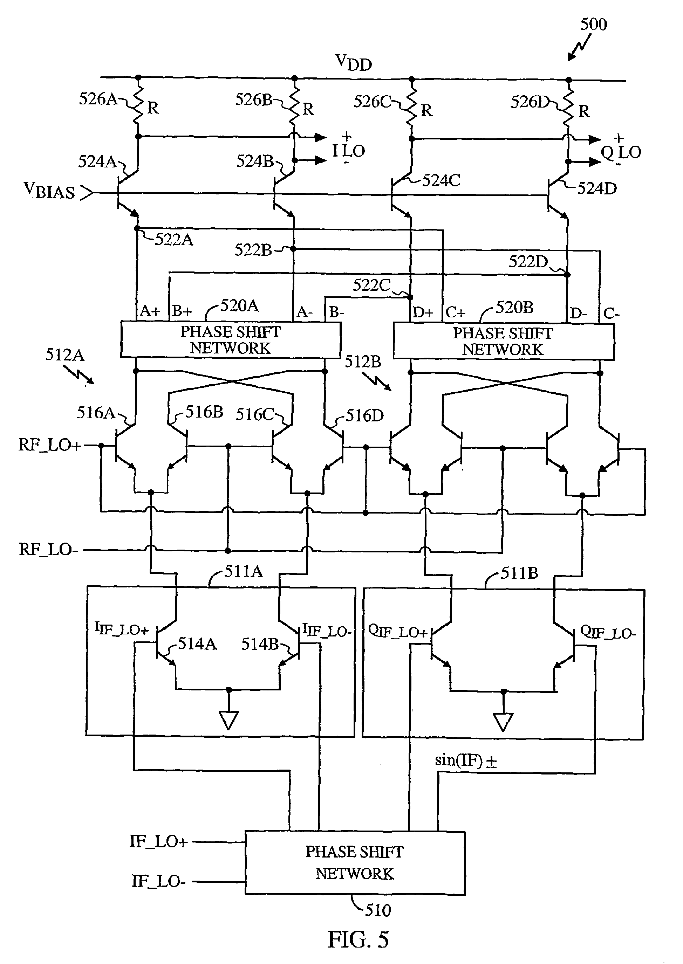

FIG. 5 shows a block diagram of a specific embodiment of a LO generator 500. LO generator 500 is a specific implementation of LO generator 400 in FIG. 4 and can be used for LO generator 240 in FIG. 2. Phase shift networks 510, 520a, and 520b in FIG. 5 correspond to phase shift networks 410, 420a, and 420b, respectively, in FIG. 4. Mixers 512a and 512b in FIG. 5 correspond to mixers 412a and 412b, respectively, in FIG. 4. Summers 422a and 422b are implemented by coupling together the outputs from phase shift networks 520a and 520b.

Within generator 500, the differential IF LO (IF_LO+ and IF_LO-) is provided to phase shift network 510 that provides a differential inphase IF LO ($I_{IF\_LO+}$ and $I_{IF\_LO}$) and a differential quadrature IF LO ($Q_{IF\_LO+}$ and $Q_{IF\_LO}$). The differential RF LO (RF_LO+ and RF_LO-) and the differential inphase IF LO are provided to mixer 512a, and the differential RF LO and the differential quadrature IF LO are provided to mixer 512b.

In the embodiment shown in FIG. 5, each mixer 512 is implemented using a Gilbert cell multiplier comprising a differential amplifier 514 coupled to a pair of cross-coupled differential amplifiers 516. Specifically, for mixer 512a, the $I_{IF\_LO+}$ and $I_{IF\_LO-}$ are provided to the inputs of a transconductor 511a, which in the embodiment shown in FIG. 5 is implemented as a differential amplifier comprised of transistors 514a and 514b. Although not shown in FIG. 5, emitter degeneration resistors can be coupled between the emitter of transistors 514a and 514b and ground to improve the linearity of the differential amplifier. If $I_{IF\_LO+}$ and $I_{IF\_LO-}$ are current signals, they can be directly applied to the Gilbert cell mixers. The emitters of transistors 514a and 514b couple together and to AC ground. The collector of transistor 514a couples to the emitters of transistors 516a and 516b, and the collector of transistor 514b couples to the emitters of transistors 516c and 516d. The collectors of transistors 516a and 516c couple together and to phase shift network 520a, and the collectors of transistors 516b and 516d couple together and also to phase shift network 520a. The bases of transistors 516a and 516d couple together and receive the RF_LO+, and the bases of transistors 516b and 516c couple together and receive the RF_LO-. Mixer 512b is configured similar to mixer 512a.

Each phase shift network 520 receives a differential input signal and generates four phases of the received signal, or two differential signals that are in quadrature with respect to each other. The four phases include $\phi$, $\phi$+90°, $\phi$+180°, and $\phi$+270°, where $\phi$ is an arbitrary phase value but is similar for both phase shift networks 520a and 520b. The outputs from phase shift networks 520a and 520b are current signals, and are combined at nodes 522a through 522d to generate the desired output signals. Transistors 524a through 524d are cascode buffers that isolate output resistors 526 from phase shift networks 520. The cascode buffers prevent resistors 526 from loading and affecting the performance of the phase shift networks. The current through each cascode buffer generates a voltage across the respective load resistor 526. The voltages at resistors 526a and 526b comprise the differential inphase LO (I LO+ and I LO-) and the voltages at resistors 526c and 526d comprise the differential quadrature LO (Q LO+ and Q LO-).

FIG. 5 shows a specific implementation of LO generator 400. Various other designs can also be used for each element of the LO generator. For example, the phase shift network can be implemented as an etched element on a circuit board using coupled transmission lines (as disclosed in the aforementioned U.S. Patent No. 5,412,351), a Wilkinson structure, or other distributed techniques that are known in the art. The phase shift network can also be implemented using lump elements, such as a hybrid coupler that is commercially available. The phase shift network can also be implemented using a delay locked loop that corrects for phase error and/or amplitude imbalance in the inphase and quadrature sinusoids via a feedback loop. The phase shift network can also be implemented using active devices. An example design of a phase shift network using active devices is disclosed U.S. Patent Application Serial No. 08/862,094, entitled "Active Phase Splitter," filed May, 22, 1997.

Similarly, the mixers can be implemented using many designs. The mixers can be implemented as single balance or double balance diode mixers, as is known in the art. Alternatively, the mixers can be implemented with Gilbert cell multipliers comprising active devices, as shown above. In general, the mixers can be implemented using non-linear devices. Therefore, the various implementations of the mixers can be contemplated and are within the scope of the present invention.

In the embodiment shown above, the summers are implemented by coupling together the (current) outputs of the phase shift networks. The summers can also be implemented with passive summing elements (such as resistive networks) or active circuits (such as summing amplifiers).

The specific implementation shown in FIG. 5 includes many advantages. First, the mixers, phase shift networks, summers, and output buffers are implemented with a "stacked" circuit topology and share four current paths (i.e., through resistors 526a through 526d) corresponding to the four output signals (or two differential LOs). By sharing currents, the stacked topology reduces power consumption and also reduces the number of required components by eliminating the need for buffers and other circuits.

Second, phase shift networks 520a and 520b each generates four phases of the input signal. The four phases correspond to two differential output signals that are in quadrature with respect to each other. For a differential signal, the inverted signal can be easily obtained by simply swapping the two signal lines. For example, referring to FIG. 4, the minus sign on summer 422b for component *b* can be obtained by swapping the differential signal lines (b+ and *b*-). Thus, the sum and difference frequency components can be readily obtained with the same circuit by properly combining the output signals from phase shift networks 520a and 520b. The sum and difference frequency components can also be obtained by swapping the polarity of the differential lines coupling mixer 412a to phase shift network 420a.

LO generator 500 is one implementation of LO generator 400. Other implementations can also be designed and are within the scope of the invention. For example, a "cascaded" topology can be used in which the mixers operate from one set of current paths and the phase shift networks and output buffers operate from a second set of current paths. The cascaded topology may be used, for example, in applications having low supply voltages.

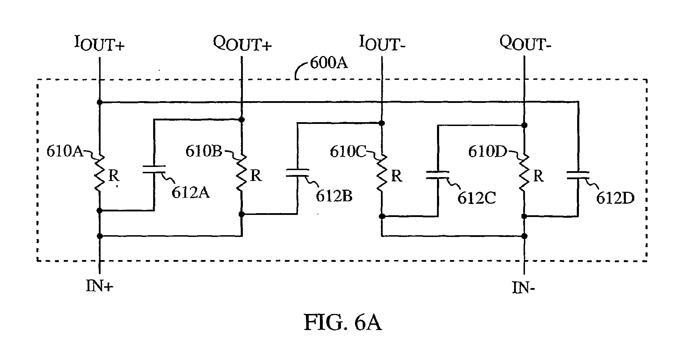

FIG. 6A shows a block diagram of a specific embodiment of a single-pole phase shift network 600a. Phase shift network 600a can be used to implement the phase shift networks in FIGS. 4 and 5. Phase shift network 600a is a polyphase filter that receives a differential input signal (IN+ and IN-) and generates a pair of differential output signals ($I_{OUT+}$ and $I_{OUT-}$, and $Q_{OUT+}$ and $Q_{OUT-}$).

Within network 600a, the signal IN+ is provided to one end of resistors 610a and 610b and capacitors 612a and 612b. Similarly, the signal IN- is provided to one end of resistors 610c and 610d and capacitors 612c and 612d. The other end of resistors 610a, 610b, 610c, and 610d couple to the other end of capacitors 612d, 612a, 612b, and 612c, respectively, and comprise the outputs $I_{OUT+}$, $Q_{OUT+}$, $I_{OUT-}$, and $Q_{OUT-}$, respectively. The transfer functions for network 600a are as follows:

$$V_{Iout+} = \frac{V_{IN}}{2}\left(\frac{1 - sR_1C_1}{1 + sR_1C_1}\right), \qquad \text{Eq. (8)}$$

$$V_{Qout+} = \frac{V_{IN}}{2}\left(\frac{1 + sR_1C_1}{1 + sR_1C_1}\right), \qquad \text{Eq. (9)}$$

$$V_{Iout-} = -\frac{V_{IN}}{2}\left(\frac{1 - sR_1C_1}{1 + sR_1C_1}\right), \qquad \text{Eq. (10)}$$

and

$$V_{Qout-} = -\frac{V_{IN}}{2}\left(\frac{1+sR_1C_1}{1+sR_1C_1}\right) , \qquad \text{Eq. (11)}$$

where $V_{IN} = V_{IN+} - V_{IN-}$. The differential transfer functions can be expressed as:

$$V_{Iout} = V_{IN}\left(\frac{1-sR_1C_1}{1+sR_1C_1}\right) , \qquad \text{Eq. (12)}$$

and

$$V_{Qout} = V_{IN}\left(\frac{1+sR_1C_1}{1+sR_1C_1}\right) . \qquad \text{Eq. (13)}$$

where $V_{Iout} = V_{Iout+} - V_{Iout-}$ and $V_{Qout} = V_{Qout+} - V_{Qout-}$.

Phase shift network 600a is approximately an allpass structure. Each RC network (e.g., resistor 610b and capacitor 612a) provides 45 degrees of phase shift relative to an adjacent network. The coupling capacitors 612b and 612d cross-couple the input differential signals (IN+ and IN-).

Referring to FIG. 4, phase shift network 410 operates on a band at the IF frequency (e.g., single tone IF LO or a variable frequency IF LO to accommodate different frequency plans), and each of phase shift networks 420a and 420b operates on a wideband (e.g., adjustable frequency for channel selection) signal having a summed frequency component (e.g., $\cos(\omega_{Rf} - \omega_{IF})$) and a difference frequency component (e.g., $\cos(\omega_{RF} + \omega_{IF})$), as indicated in equations (1) through (4). For each phase shift network, the resistors and capacitors are selected to provide the required phase and amplitude responses at the frequency of operation and over the band of interest. Thus, the resistance and capacitance values for phase shift network 410 are likely to be different from those of phase shift networks 420a and 420b.

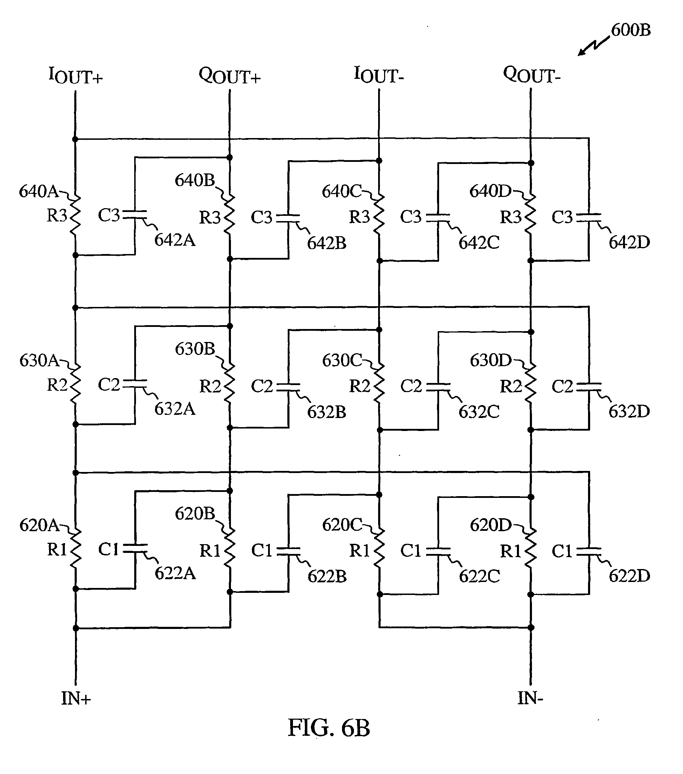

FIG. 6B shows a block diagram of a specific embodiment of a three-pole phase shift network 600b. Phase shift network 600b can also be used to implement the phase shift networks in FIGS. 4 and 5. Phase shift network 600b has a wider bandwidth than phase shift network 600a, and is especially suited for use as phase shift networks 420 in FIG. 4 and phase shift networks 520 in FIG. 5.

Within network 600b, the signal IN+ is provided to one end of resistors 620a and 620b and capacitors 622a and 622b. Similarly, the signal IN- is provided to one end of resistors 620c and 620d and capacitors 622c and 622d. The other end of resistors 620a, 620b, 620c, and 620d couple to the other end of capacitors 622d, 622a, 622b, and 622c, respectively. Resistors 620 and capacitors 622 form the first stage that provides one pole.

Resistors 620a, 620b, 620c, and 620d couple to one end of resistors 630a, 630b, 630c, and 630d, respectively, and to one end of capacitors 632a, 632b, 632c, and 632d, respectively. The other end of capacitors 632a, 632b, 632c, and 632d couple to the other end of resistors 630b, 630c, 630d, and 630a, respectively. Resistors 630 and capacitors 632 form the second stage.

Resistors 630a, 630b, 630c, and 630d couple to one end of resistors 640a, 640b, 640c, and 640d, respectively, and to one end of capacitors 642a, 642b, 642c, and 642d, respectively. The other end of capacitors 642a, 642b, 642c, and 642d couple to the other end of resistors 640b, 640c, 640d, and 640a, respectively. Resistors 640 and capacitors 642 form the third stage. Resistors 640a, 640b, 640c, and 640d comprise the outputs $I_{OUT}+$, $Q_{OUT+}$, $I_{OUT}-$, and $Q_{OUT-}$, respectively.

The first stage of phase shift network 600b provides the phase shifting to generate four phases (e.g., $\phi$, $\phi+90°$, $\phi+180°$, and $\phi+270°$) of the input signal, or two differential signals that are in quadrature with respect to each other. Each stage provides a pole that can be placed at a desired frequency location by proper selection of the resistance and capacitance values. Specifically, the pole locations can be expressed as:

$$f_1 = 2\pi \ R_1 C_1 \ ,$$ 

Eq. (14)

$$f_2 = 2\pi \ R_2 C_2 = \sqrt{f_1 f_3} \ , \text{and}$$

Eq. (15)

$$f_3 = 2\pi \ R_3 C_3 \ .$$ 

Eq. (16)

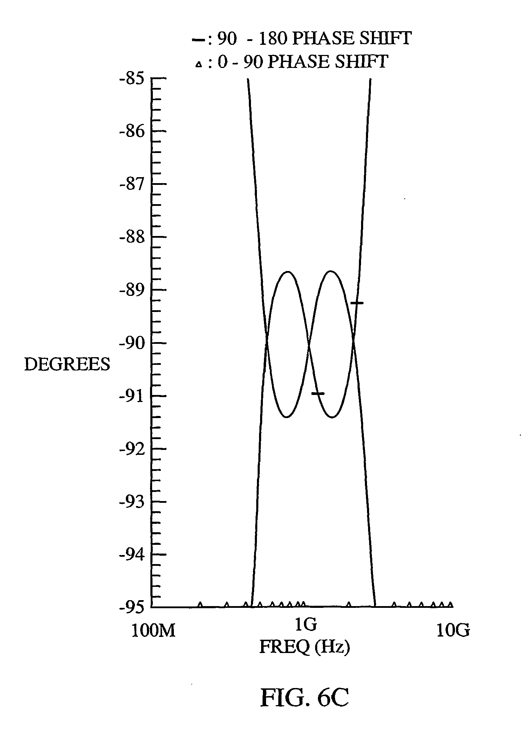

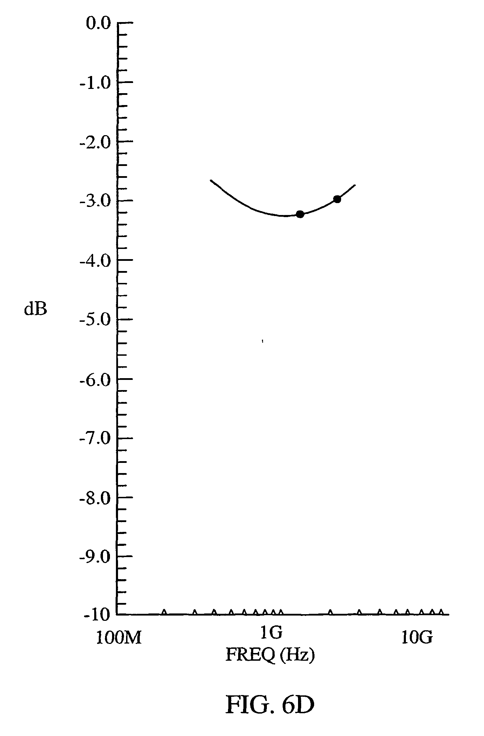

FIGS. 6C and 6D show the phase and amplitude responses, respectively, of phase shift network 600b. In a specific implementation, the poles are set at $f_1$ = 600 MHz, $f_2$ = 1150 MHz, and $f_3$ = 2.2 GHz. It can be noted that the typical phase error is less than 1.5 degrees over the bandwidth of interest, and the typical amplitude error is less than 0.5 dB. Generally, tolerance error in the R and C values shifts the poles, and mismatch in the resistors and capacitors produces phase errors. Tolerance error and mismatch can be reduced by observing proper design layout guidelines.

FIGS. 6A and 6B show specific designs of a specific type of phase shift network. Other designs can also be implemented and are within the scope of the invention. For example, the phase shift network can be designed to include any number of poles (e.g., 1,2,3,4,5, and so on).

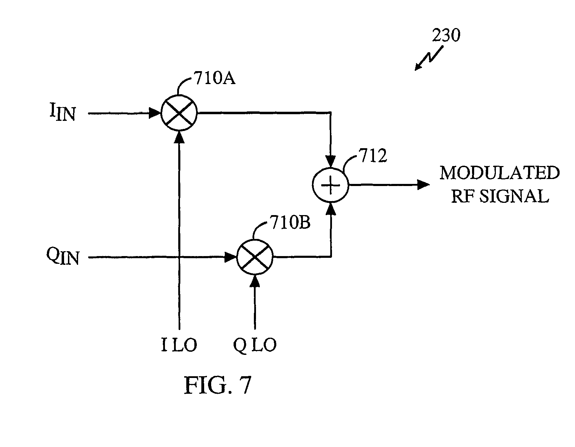

FIG. 7 shows a block diagram of a specific embodiment of direct upconverted 230. The I and Q signals are provided to mixers 710a and 710b, respectively, that also receive the I LO and Q LO, respectively. Each mixer 710 modulates the input signal with the LO signal to generate a modulated component. The modulated components are provided to a summer 712 that sums the components to generate the modulated RF signal. Mixers 710 and summer 712 can be implemented using a pair of Gilbert cell multipliers, similar to that shown in FIG. 5.

For clarity, the LO generator of the invention has been described for a QPSK modulator within a transmitter. The LO generator can also be used in a direct downconverter that receives a RF signal and directly demodulates or downconverts the received RF signal to generate a demodulated and/or downconverted (baseband) signal.

The invention has also been described with circuitry implemented using bipolar junction transistors (BJTs). The invention can also be implemented with other circuits including FETs, MOSFETs, MESFETs, HBTs, P-HEMTs, and others. As used herein, "transistor" generically refers to any active circuit, and is not limited to a BJT.

As used herein, a sinusoid is one type of a carrier signal that is used for modulation, demodulation, and frequency conversion. Generally, a carrier signal can be of other types such as a square wave, a sawtooth, a triangular wave, and so on. The invention as described herein can be used to generate any type of carrier signal, and is not limited to the generation of sinusoids.

The foregoing description of the preferred embodiments is provided to enable any person skilled in the art to make or use the present invention. Various modifications to these embodiments will be readily apparent to those skilled in the art, and the generic principles defined herein may be applied to other embodiments without the use of the inventive faculty. Thus, the present invention is not intended to be limited to the embodiments shown herein but is to be accorded the widest scope consistent with the principles and novel features disclosed herein.

**Claims**

1. A signal generator (400) comprising:

   a first mixer (412A) configured to receive and mix a quadrature sinusoid at a first frequency with a second input sinusoid at a second frequency, the first frequency being a local oscillator intermediate frequency of a communication device (100), the second frequency being a local oscillator radio frequency of the communication device; a second mixer (412B) configured to receive and mix an inphase sinusoid at the first frequency with the second input sinusoid; wherein the signal generator (400) is **characterised in** further comprising:

   a first phase shift network (420A) coupled to the first mixer, the first phase shift network configured to receive an output from the first mixer and generate a first phase shifted signal; a second phase shift network (420B) coupled to the second mixer, the second phase shift network configured to receive an output from the second mixer and generate a second phase shifted signal; and

a first summer (422A) coupled to the first and second phase shift networks, the first summer configured to receive and sum the first and second phase shifted signals to generate a first output signal;

wherein the first output signal comprises a first output sinusoid at a frequency equal to difference between the local oscillator radio frequency and the local oscillator intermediate frequency, and wherein frequency component at a frequency equal to sum of the local oscillator intermediate frequency and local oscillator radio frequency is cancelled in the first output signal;

wherein the first phase shift network (420A)is further configured to generate a third phase shifted signal and the second phase shift network (420B) is further configured to generate a fourth phase shifted signal, and wherein the generator (400) further comprises:

a second summer (422B) coupled to the first and second phase shift networks, the second summer configured to receive the third and fourth phase shifted signals to generate a second output signal and to subtract the third phase shifted signal from the fourth phase shifted signal;

wherein the second output signal comprises a second output sinusoid at a frequency equal to the difference of the local oscillator radio frequency and the local oscillator intermediate frequency;

wherein the frequency component at a frequency equal to the sum between the local oscillator radio frequency and the local oscillator intermediate frequency is cancelled in the second output signal;

wherein the third phase shifted signal is about ninety degrees offset from the first phase shifted signal; the second phase shifted signal is about ninety degrees offset from the fourth phase shifted signal; and wherein the first and the second output sinusoids are in quadrature.

2. The generator of claim 1, further comprising:

a third phase shift network (410A) configured to receive a first input sinusoidal at the first frequency and generate the inphase and quadrature sinusoids.

3. The generator of claim 1, wherein each of the sinusoids is provided with a differential signal.

4. The generator of claim 1, wherein the inphase and quadrature sinusoids are approximately 90 degrees out of phase with respect to each other.

5. The signal generator of claim 1, further **characterised in that** the first mixer comprises a first Gilbert cell multiplier, and the second mixer comprises a second Gilbert cell multiplier.

6. The generator of claim 5, further comprising:

a third phase shift network (410A) configured to receive a first input sinusoidal at the first frequency and generate the inphase and quadrature sinusoids at the first frequency.

7. The generator of claim 5, wherein the first and second phase shift networks are implemented with polyphase filters.

8. A method of generating local oscillator sinusoids for direct upconvertion to a transmission frequency of a wireless communication device (100), the method comprising:

mixing a first quadrature sinusoid at a first frequency with a second input sinusoid at a second frequency to generate a first mixed signal, the first frequency being a local oscillator intermediate frequency of the wireless communication device, the second frequency being a local oscillator radio frequency of the wireless communication device;

mixing a first inphase sinusoid at the first frequency with the second input sinusoid to generate a second mixed signal;

phase shifting the first mixed signal to generate a first inphase signal and a first quadrature signal;

phase shifting the second mixed signal to generate a second inphase signal and a second quadrature signal; and combining the first inphase signal and the second quadrature signal to generate a first output signal, wherein the first output signal comprises a first output sinusoid at a frequency equal to difference between the local oscillator radio frequency and the local oscillator intermediate frequency, and wherein frequency component at a frequency equal to sum of the local oscillator intermediate frequency and local oscillator radio frequency is cancelled in the first output signal, and wherein the transmission frequency is equal to the difference between the local oscillator radio frequency and the local oscillator intermediate frequency

combining the first quadrature signal and the second inphase signal to generate a second output signal; wherein the second output signal comprises a second output sinusoid at a frequency equal to the difference of the local oscillator radio frequency and the local oscillator intermediate frequency;

and wherein the frequency component at a frequency equal to the sum between the local oscillator radio frequency and the local oscillator intermediate frequency is cancelled in the second output signal; and wherein the first and the second output sinusoids are in quadrature.

9. A signal generator (400) comprising:

a first mixer (412A) configured to receive and mix a quadrature sinusoid at a first frequency with a second input sinusoid at a second frequency, the first frequency being a local oscillator intermediate frequency of a communication device (100), the second frequency being a local oscillator radio frequency of the communication device; a second mixer (412B) configured to receive and mix an inphase sinusoid at the ' first frequency with the second input sinusoid;

wherein the signal generator (400) is **characterised in** further comprising:

a first phase shift network (420A) coupled to the first mixer, the first phase shift network configured to receive an output from the first mixer and generate a first phase shifted signal; a second phase shift network (420B) coupled to the second mixer, the second phase shift network configured to receive an output from the second mixer and generate a second phase shifted signal; and a first summer (422A) coupled to the first and second phase shift networks, the first summer configured to receive and sum the opposite of the first phase shifted signal and the second phase shifted signal to generate a first output signal;

wherein the first output signal comprises a first output sinusoid at a frequency equal to sum between the local oscillator radio frequency and the local oscillator intermediate frequency, and wherein frequency component at a frequency equal to difference of the local oscillator intermediate frequency and local oscillator radio frequency is cancelled in the first output signal; wherein the first phase shift network (420A)is further configured to generate a third phase shifted signal and the second phase shift network (420B) is further configured to generate a fourth phase shifted signal, and wherein the generator (400) further comprises:

a second summer (422B) coupled to the first and second phase shift networks, the second summer configured to receive the third and fourth phase shifted signals to henerate a second output signal and to subtract the opposite of the third phase shifted signal from the fourth phase shifted signal; wherein the second output signal comprises a second output sinusoid at a frequency equal to the sum of the local oscillator radio frequency and the local oscillator intermediate frequency; wherein the frequency component at a frequency equal to the difference between the local oscillator radio frequency and the local oscillator intermediate frequency is cancelled in the second output signal; wherein the third phase shifted signal is about ninety degrees offset from the first phase shifted signal; the second phase shifted signal is about ninety degrees offset from the fourth phase shifted signal; and wherein the first and the second output sinusoids are in quadrature.

10. A method of generating local oscillator sinusoids for direct upconvertion to a transmission frequency of a wireless communication device (100), the method comprising:

mixing a first quadrature sinusoid at a first frequency with a second input sinusoid at a second frequency to generate a first mixed signal, the first frequency being a local oscillator intermediate frequency of the wireless communication device, the second frequency being a local oscillator radio frequency of the wireless communication device; mixing a first inphase sinusoid at the first frequency with the second input sinusoid to generate a second mixed signal; phase shifting the first mixed signal to generate a first inphase signal and a first quadrature signal; phase shifting the second mixed signal to generate a second inphase signal and a second quadrature signal; and combining the first inphase signal and the second quadrature signal to generate a first output signal, wherein the first output signal comprises a first output sinusoid at a frequency equal to sum between the local oscillator radio frequency and the local oscillator intermediate frequency, and wherein frequency component at a frequency equal to difference of the local oscillator intermediate frequency and local oscillator radio frequency is cancelled in the first output signal, and wherein the transmission frequency is equal to the sum between the local oscillator radio frequency and the local oscillator intermediate frequency

combining the first quadrature signal and the second inphase signal to generate a second output signal; wherein the second output signal comprises a second output sinusoid at a frequency equal to the sum of the local oscillator radio frequency and the local oscillator intermediate frequency;

and wherein the frequency component at a frequency equal to the difference between the local oscillator radio frequency and the local oscillator intermediate frequency is cancelled in the second output signal; and

wherein the first and the second output sinusoids are in quadrature.

**11.** A modulator comprising:

the signal generator of claim 1 or claim 9; and
a direct upconverter (230) configured to receive and mix at least one analog signal and the first output signal to provide a modulated signal.

**12.** A transmitter in a cellular telephone comprising:

the signal generator of claim 1 or claim 9;
at least one buffer (222) configured to receive at least one analog signal and to output buffered said at least one analog signal;
a direct upconverter (230) operatively coupled to the at least one buffer, the upconverter configured to receive and mix the buffered said at least one analog signal with the first output signal to provide a modulated signal;
at least one variable gain amplifier (VGA 250) operatively coupled to the direct upconverter, the VGA configured to receive and amplify the modulated signal.

**Patentansprüche**

**1.** Ein Signalgenerator (400), der Folgendes aufweist:

ein erstes Mischelement (412A), das konfiguriert ist zum Empfangen und Mischen einer Quadratur-Sinuswelle auf einer ersten Frequenz mit einer zweiten Eingangssinuswelle auf einer zweiten Frequenz, wobei die erste Frequenz eine Lokaloszillatorzwischenfrequenz einer Kommunikationseinrichtung (100) ist; wobei die zweite Frequenz eine Lokaloszillatorhochfrequenz der Kommunikationseinrichtung ist;
ein zweites Mischelement (412B), das konfiguriert ist zum Empfangen und Mischen einer Inphase-Sinuswelle auf einer ersten Frequenz mit der zweiten Eingangssinuswelle;
wobei der Signalgenerator (400) **dadurch gekennzeichnet ist, dass** er weiter Folgendes aufweist:

ein erstes Phasenverschiebungsnetzwerk (420A), das an das erste Mischelement gekoppelt ist, wobei das erste Phasenverschiebungsnetzwerk konfiguriert ist zum Empfangen einer Ausgabe von dem ersten Mischelement und zum Generieren eines ersten phasenverschobenen Signals;
ein zweites Phasenverschiebungsnetzwerk (420B), das an das zweite Mischelement gekoppelt ist, wobei das zweite Phasenverschiebungsnetzwerk konfiguriert ist zum Empfangen einer Ausgabe von dem zweiten Mischelement und zum Generieren eines zweiten phasenverschobenen Signals; und
ein erstes Summierelement (422A), das an das erste und zweite Phasenverschiebungsnetzwerk gekoppelt ist, wobei das erste Summierelement konfiguriert ist zum Empfangen und Summieren der ersten und zweiten phasenverschobenen Signale, um ein erstes Ausgangssignal zu erzeugen;

wobei das erste Ausgangssignal eine erste Ausgangssinuswelle auf einer Frequenz gleich der Differenz zwischen der Lokaloszillatorhochfrequenz und der Lokaloszillatorzwischenfrequenz aufweist, und wobei eine Frequenzkomponente bei einer Frequenz gleich der Summe der Lokaloszillatorzwischenfrequenz und der Lokaloszillatorhochfrequenz im ersten Ausgangssignal ausgelöscht wird;
wobei das erste Phasenverschiebungsnetzwerk (420A) weiter konfiguriert ist zum Generieren eines dritten phasenverschobenen Signals und das zweite Phasenverschiebungsnetzwerk (420B) weiter konfiguriert ist zum Generieren eines vierten phasenverschobenen Signals, und wobei der Generator (400) weiter Folgendes aufweist:

ein zweites Summierelement (422B), das an das erste und zweite Phasenverschiebungsnetzwerk gekoppelt ist, wobei das zweite Summierelement konfiguriert ist zum Empfangen der dritten und vierten phasenverschobenen Signale,
um ein zweites Ausgangssignal zu generieren und zum Subtrahieren des dritten phasenverschobenen Signals von dem vierten phasenverschobenen Signal;
wobei das zweite Ausgangssignal eine zweite Ausgangssinuswelle bei einer Frequenz gleich der Differenz der Lokaloszillatorhochfrequenz und der Lokaloszillatorzwischenfrequenz aufweist;
wobei die Frequenzkomponenten bei einer Frequenz gleich der Summe der Lokaloszillatorhochfrequenz und der Lokaloszillatorzwischenfrequenz in dem zweiten Ausgangssignal ausgelöscht wird;
wobei das dritte phasenverschobene Signal ungefähr neunzig Grad vom ersten phasenverschobenen Signal versetzt ist;
wobei das zweite phasenverschobene Signal ungefähr neunzig Grad von dem vierten phasenverschobenen Signal versetzt ist; und
wobei die ersten und die zweiten Ausgangssinuswellen in Quadratur vorliegen.

2.   Generator nach Anspruch 1, der weiter Folgendes aufweist:

ein drittes Phasenverschiebungsnetzwerk (410A), das konfiguriert ist zum Empfangen einer ersten Eingangssinuswelle auf der ersten Frequenz und zum Generieren der Inphase- und Quadratur-Sinuswellen.

3.   Generator nach Anspruch 1, wobei jede der Sinuswellen mit einem unterschiedlichen Signal vorgesehen wird.

4.   Generator nach Anspruch 1, wobei die Inphase- und Quadratur-Phase-Sinuswellen näherungsweise 90 Grad außer Phase in Bezug aufeinander sind.

5.   Signalgenerator nach Anspruch 1, der weiter **dadurch gekennzeichnet ist, dass** das erste Mischelement einen ersten Gilbert-Zellen-Multiplizierer aufweist, und das zweite Mischelement einen zweiten Gilbert-Zellen-Multiplizierer aufweist.

6.   Generator nach Anspruch 5, der weiter Folgendes aufweist:

ein drittes Phasenverschiebungsnetzwerk (410A), das konfiguriert ist, um eine erste Eingangssinuswelle auf einer ersten Frequenz zu empfangen und die Inphasen- und Quadratur-Sinuswellen auf der ersten Frequenz zu generieren.

7.   Generator nach Anspruch 5, wobei die ersten und zweiten Phasenverschiebungsnetzwerke mit Polyphasenfiltern implementiert sind.

8.   Ein Verfahren zum Generieren von Lokaloszillatorsinuswellen zur direkten Aufwärtskonvertierung auf eine Sende- bzw. Übertragungsfrequenz einer Drahtloskommunikationseinrichtung (100), wobei das Verfahren Folgendes aufweist:

Mischen einer ersten Quadratursinuswelle auf einer ersten Frequenz mit einer zweiten Eingangssinuswelle auf einer zweiten Frequenz zum Generieren eines ersten gemischten Signals, wobei die erste Frequenz eine Lokaloszillatorzwischenfrequenz der Drahtloskommunikationseinrichtung ist, wobei die zweite Frequenz eine Lokaloszillatorhochfrequenz der Drahtloskommunikationseinrichtung ist;
Mischen einer ersten Inphase-Sinuswelle auf der ersten Frequenz mit der zweiten Eingangssinuswelle, um ein zweites gemischtes Signal zu erzeugen;
Phasenverschieben des ersten gemischten Signals, um ein erstes Inphase-Signal und ein erstes Quadratur-Signal zu erzeugen;
Phasenverschieben des zweiten gemischten Signals, um ein zweites Inphase-Signal und ein zweites Quadratur-Signal zu erzeugen; und
Kombinieren des ersten Inphase-Signals und des zweiten Quadratur-Signals, um ein erstes Ausgangssignal zu erzeugen, wobei das erste Ausgangssignal eine erste Ausgangssinuswelle auf einer Frequenz gleich der Differenz zwischen der Lokaloszillatorhochfrequenz und der Lokaloszillatorzwischenfrequenz aufweist, und wobei die Frequenzkomponente auf einer Frequenz gleich der Summe der Lokaloszillatorzwischenfrequenz und der Lokaloszillatorhochfrequenz im ersten Ausgangssignal ausgelöscht wird, und wobei die Sende- bzw. Übertragungsfrequenz gleich der Differenz zwischen der Lokaloszillatorhochfrequenz und der Lokaloszillatorzwischenfrequenz ist;
Kombinieren des ersten Quadratur-Signals und des zweiten Inphase-Signals zum Generieren eines zweiten Ausgangssignals;
wobei das zweite Ausgangssignal eine zweite Ausgangssinuswelle auf einer Frequenz gleich der Differenz der Lokaloszillatorhochfrequenz und der Lokaloszillatorzwischenfrequenz aufweist;
und wobei die Frequenzkomponente auf einer Frequenz gleich der Summe der Lokaloszillatorhochfrequenz und der Lokaloszillatorzwischenfrequenz in dem zweiten Ausgangssignal ausgelöscht wird; und
wobei die ersten und zweiten Ausgangssinuswellen in Quadratur vorliegen.

9. Ein Signalgenerator (400), der Folgendes aufweist:

ein erstes Mischelement (412A), das konfiguriert ist zum Empfangen und Mischen einer Quadratur-Sinuswelle auf einer ersten Frequenz mit einer zweiten Eingangssinuswelle auf einer zweiten Frequenz, wobei die erste Frequenz eine Lokaloszillatorzwischenfrequenz einer Kommunikationseinrichtung (100) ist; wobei die zweite Frequenz eine Lokaloszillatorhochfrequenz der Kommunikationseinrichtung ist;
ein zweites Mischelement (412B), das konfiguriert ist zum Empfangen und Mischen einer Inphase-Sinuswelle auf einer ersten Frequenz mit der zweiten Eingangssinuswelle;
wobei der Signalgenerator (400) **dadurch gekennzeichnet ist, dass** er weiter Folgendes aufweist:

ein erstes Phasenverschiebungsnetzwerk (420A), das an das erste Mischelement gekoppelt ist, wobei das erste Phasenverschiebungsnetzwerk konfiguriert ist zum Empfangen einer Ausgabe von dem ersten Mischelement und zum Generieren eines ersten phasenverschobenen Signals;
ein zweites Phasenverschiebungsnetzwerk (420B), das an das zweite Mischelement gekoppelt ist, wobei das zweite Phasenverschiebungsnetzwerk konfiguriert ist zum Empfangen einer Ausgabe von dem zweiten Mischelement und zum Generieren eines zweiten phasenverschobenen Signals; und
ein erstes Summierelement (422A), das an das erste und zweite Phasenverschiebungsnetzwerk gekoppelt ist, wobei das erste Summierelement konfiguriert ist zum Empfangen und Summieren des Entgegengesetzten des ersten phasenverschobenen Signals und des zweiten phasenverschobenen Signals, um ein erstes Ausgangssignal zu erzeugen;

wobei das erste Ausgangssignal eine erste Ausgangssinuswelle auf einer Frequenz gleich der Summe der Lokaloszillatorhochfrequenz und der Lokaloszillatorzwischenfrequenz aufweist, und wobei eine Frequenzkomponente auf einer Frequenz gleich der Differenz der Lokaloszillatorzwischenfrequenz und der Lokaloszillatorhochfrequenz im ersten Ausgangssignal ausgelöscht wird;
wobei das erste Phasenverschiebungsnetzwerk (420A) weiter konfiguriert ist zum Generieren eines dritten phasenverschobenen Signals und das zweite Phasenverschiebungsnetzwerk (420B) weiter konfiguriert ist zum Generieren eines vierten phasenverschobenen Signals, und wobei der Generator (400) weiter Folgendes aufweist:

ein zweites Summierelement (422B), das an das erste und zweite Phasenverschiebungsnetzwerk gekoppelt ist, wobei das zweite Summierelement konfiguriert ist zum Empfangen der dritten und vierten phasenverschobenen Signale,
um ein zweites Ausgangssignal zu generieren und zum Subtrahieren des Entgegengesetzten des dritten phasenverschobenen Signals von dem vierten phasenverschobenen Signal;
wobei das zweite Ausgangssignal eine zweite Ausgangssinuswelle bei einer Frequenz gleich der Summe der Lokaloszillatorhochfrequenz und der Lokaloszillatorzwischenfrequenz aufweist;
wobei die Frequenzkomponente bei einer Frequenz gleich der Differenz zwischen der Lokaloszillatorhochfrequenz und der Lokaloszillatorzwischenfrequenz in dem zweiten Ausgangssignal ausgelöscht wird;
wobei das dritte phasenverschobene Signal ungefähr neunzig Grad vom ersten phasenverschobenen Signal versetzt ist;
wobei das zweite phasenverschobene Signal ungefähr neunzig Grad von dem vierten phasenverschobenen Signal versetzt ist; und
wobei die ersten und die zweiten Ausgangssinuswellen in Quadratur vorliegen.

10. Ein Verfahren zum Generieren von Lokaloszillatorsinuswellen zur direkten Aufwärtskonvertierung auf eine Sende- bzw. Übertragungsfrequenz einer Drahtloskommunikationseinrichtung (100), wobei das Verfahren Folgendes aufweist:

Mischen einer ersten Quadratursinuswelle auf einer ersten Frequenz mit einer zweiten Eingangssinuswelle auf einer zweiten Frequenz zum Generieren eines ersten gemischten Signals, wobei die erste Frequenz eine Lokaloszillatorzwischenfrequenz der Drahtloskommunikationseinrichtung ist, wobei die zweite Frequenz eine Lokaloszillatorhochfrequenz der Drahtloskommunikationseinrichtung ist;

Mischen einer ersten Inphase-Sinuswelle auf der ersten Frequenz mit der zweiten Eingangssinuswelle, um ein zweites gemischtes Signal zu erzeugen;

Phasenverschieben des ersten gemischten Signals, um ein erstes Inphase-Signal und ein erstes Quadratur-Signal zu erzeugen;

Phasenverschieben des zweiten gemischten Signals, um ein zweites Inphase-Signal und ein zweites Quadratur-Signal zu erzeugen; und

Kombinieren des ersten Inphase-Signals und des zweiten Quadratur-Signals, um ein erstes Ausgangssignal zu erzeugen, wobei das erste Ausgangssignal eine erste Ausgangssinuswelle auf einer Frequenz gleich der Summe der Lokaloszillatorhochfrequenz und der Lokaloszillatorzwischenfrequenz aufweist, und wobei die Frequenzkomponente auf einer Frequenz gleich der Differenz der Lokaloszillatorzwischenfrequenz und der Lokaloszillatorhochfrequenz im ersten Ausgangssignal ausgelöscht wird, und wobei die Sende- bzw. Übertragungsfrequenz gleich der Summe der Lokaloszillatorhochfrequenz und der Lokaloszillatorzwischenfrequenz ist;

Kombinieren des ersten Quadratur-Signals und des zweiten Inphase-Signals zum Generieren eines zweiten Ausgangssignals;

wobei das zweite Ausgangssignal eine zweite Ausgangssinuswelle auf einer Frequenz gleich der Summe der Lokaloszillatorhochfrequenz und der Lokaloszillatorzwischenfrequenz aufweist;

und wobei die Frequenzkomponente auf einer Frequenz gleich der Differenz zwischen der Lokaloszillatorhochfrequenz und der Lokaloszillatorzwischenfrequenz in dem zweiten Ausgangssignal ausgelöscht wird; und wobei die ersten und zweiten Ausgangssinuswellen in Quadratur vorliegen.

**11.** Ein Modulator, der Folgendes aufweist:

den Signalgenerator nach Anspruch 1 oder Anspruch 9; und
einen Direktaufwärtskonvertierer (230), der konfiguriert ist zum Empfangen und Mischen wenigstens eines Analogsignals und des ersten Ausganssignals, um ein moduliertes Signal vorzusehen.

**12.** Ein Sender in einem Zellular- bzw. Mobiltelefon, der Folgendes aufweist:

den Signalgenerator nach Anspruch 1 oder Anspruch 9;
wenigstens einen Puffer (222), der konfiguriert ist zum Empfangen wenigstens eines Analogsignals und zum Ausgeben des gepufferten wenigstens einen analogen Signals;
einen Direktaufwärtskonvertierer (230), der betriebsmäßig an den wenigstens einen Puffer gekoppelt ist, wobei der Aufwärtskonvertierer konfiguriert ist zum Empfangen und Mischen des gepufferten wenigstens einen analogen Signals mit dem ersten Ausgangssignal, um ein moduliertes Signal vorzusehen;
wenigstens einen Verstärker mit variabler Verstärkung bzw. VGA (VGA = variable gain amplifier) (VGA 250), der operativ an den Direktaufwärtskonvertierer gekoppelt ist, wobei der VGA konfiguriert ist zum Empfangen und Verstärken des modulierten Signals.

**Revendications**

**1.** Générateur de signaux (400) comprenant :

un premier mélangeur (412A) agencé pour recevoir et mélanger une sinusoïde en quadrature à une première fréquence et une deuxième sinusoïde d'entrée à une deuxième fréquence, la première fréquence étant une fréquence intermédiaire d'oscillateur local d'un dispositif de communication (100), la deuxième fréquence étant une fréquence radio d'oscillateur local du dispositif de communication ;
un deuxième mélangeur (412B) agencé pour recevoir et mélanger une sinusoïde en phase à la première fréquence et la deuxième sinusoïde d'entrée ;
dans lequel le générateur de signaux (400) est **caractérisé en ce qu'**il comprend en outre :

un premier réseau déphaseur (420A) couplé au premier mélangeur, le premier réseau déphaseur étant agencé pour recevoir une sortie du premier mélangeur et générer un premier signal déphasé ;

un deuxième réseau déphaseur (420B) couplé au deuxième mélangeur, le deuxième réseau déphaseur étant agencé pour recevoir une sortie du deuxième mélangeur et générer un deuxième signal déphasé ; et un premier additionneur (422A) couplé aux premier et deuxième réseaux déphaseurs, le premier additionneur étant agencé pour recevoir et additionner les premier et deuxième signaux déphasés pour générer un premier signal de sortie ;

dans lequel le premier signal de sortie comprend une première sinusoïde de sortie à une fréquence égale à la différence entre la fréquence radio d'oscillateur local et la fréquence intermédiaire d'oscillateur local, et dans lequel la composante de fréquence à une fréquence égale à la somme de la fréquence intermédiaire d'oscillateur local et de la fréquence radio d'oscillateur local est annulée dans le premier signal de sortie ; dans lequel le premier réseau déphaseur (420A) est en outre agencé pour générer un troisième signal déphasé et le deuxième réseau déphaseur (420B) est en outre agencé pour générer un quatrième signal déphasé, et dans lequel le générateur (400) comprend en outre :

un deuxième additionneur (422B) couplé aux premier et deuxième réseaux déphaseurs, le deuxième additionneur étant agencé pour recevoir les troisième et quatrième signaux déphasés pour générer un deuxième signal de sortie et pour soustraire le troisième signal déphasé du quatrième signal déphasé ; dans lequel le deuxième signal de sortie comprend une deuxième sinusoïde de sortie à une fréquence égale à la différence entre la fréquence radio d'oscillateur local et la fréquence intermédiaire d'oscillateur local ; dans lequel la composante de fréquence à une fréquence égale à la somme de la fréquence radio d'oscillateur local et de la fréquence intermédiaire d'oscillateur local est annulée dans le deuxième signal de sortie ; dans lequel le troisième signal déphasé est décalé d'environ quatre-vingt-dix degrés par rapport au premier signal déphasé ; le deuxième signal déphasé est décalé d'environ quatre-vingt-dix degrés par rapport au quatrième signal déphasé ; et dans lequel les première et deuxième sinusoïdes de sortie sont en quadrature.

2. Générateur selon la revendication 1, comprenant en outre :

un troisième réseau déphaseur (410A) agencé pour recevoir une première sinusoïde d'entrée à la première fréquence et générer les sinusoïdes en phase et en quadrature.

3. Générateur selon la revendication 1, dans lequel chacune des sinusoïdes est fournie avec un signal différentiel.

4. Générateur selon la revendication 1, dans lequel les sinusoïdes en phase et en quadrature sont déphasées d'environ 90 degrés l'une par rapport à l'autre.

5. Générateur de signaux selon la revendication 1, **caractérisé en outre en ce que** le premier mélangeur comprend un premier multiplieur à cellule de Gilbert, et le deuxième mélangeur comprend un deuxième multiplieur à cellule de Gilbert.

6. Générateur selon la revendication 5, comprenant en outre :

un troisième réseau déphaseur (410A) agencé pour recevoir une première sinusoïde d'entrée à la première fréquence et générer les sinusoïdes en phase et en quadrature à la première fréquence.

7. Générateur selon la revendication 5, dans lequel les premier et deuxième réseaux déphaseurs sont mis en oeuvre à l'aide de filtres polyphasés.

8. Procédé pour générer des sinusoïdes d'oscillateur local pour une élévation en fréquence directe vers une fréquence de d'émission d'un dispositif de communication sans fil (100), le procédé comprenant les étapes de suivantes :

mélanger une première sinusoïde en quadrature à une première fréquence avec une deuxième sinusoïde d'entrée à une deuxième fréquence pour générer un premier signal mélangé, la première fréquence étant une fréquence intermédiaire d'oscillateur local du dispositif de communication sans fil, la deuxième fréquence étant une fréquence radio d'oscillateur local du dispositif de communication sans fil ;

mélanger une première sinusoïde en phase à la première fréquence avec la deuxième sinusoïde d'entrée pour générer un deuxième signal mélangé ;

déphaser le premier signal mélangé pour générer un premier signal en phase et un premier signal en quadrature ;

déphaser le deuxième signal mélangé pour générer un deuxième signal en phase et un deuxième signal en quadrature ; et

combiner le premier signal en phase et le deuxième signal en quadrature pour générer un premier signal de sortie, le premier signal de sortie comprenant une première sinusoïde de sortie à une fréquence égale à la différence entre la fréquence radio d'oscillateur local et la fréquence intermédiaire d'oscillateur local, et la composante de fréquence à une fréquence égale à la somme de la fréquence intermédiaire d'oscillateur local et de la fréquence radio d'oscillateur local étant annulée dans le premier signal de sortie, et la fréquence d'émission étant égale à la différence entre la fréquence radio d'oscillateur local et la fréquence intermédiaire d'oscillateur local ;

combiner le premier signal en quadrature et le deuxième signal en phase pour générer un deuxième signal de sortie ;

dans lequel le deuxième signal de sortie comprend une deuxième sinusoïde de sortie à une fréquence égale à la différence entre la fréquence radio d'oscillateur local et la fréquence intermédiaire d'oscillateur local ;

et dans lequel la composante de fréquence à une fréquence égale à la somme de la fréquence radio d'oscillateur local et de la fréquence intermédiaire d'oscillateur local est annulée dans le deuxième signal de sortie ; et

dans lequel les première et deuxième sinusoïdes de sortie sont en quadrature.

9. Générateur de signaux (400) comprenant :

un premier mélangeur (412A) agencé pour recevoir et mélanger une sinusoïde en quadrature à une première fréquence et une deuxième sinusoïde d'entrée à une deuxième fréquence, la première fréquence étant une fréquence intermédiaire d'oscillateur local d'un dispositif de communication (100), la deuxième fréquence étant une fréquence radio d'oscillateur local du dispositif de communication ;

un deuxième mélangeur (412B) agencé pour recevoir et mélanger une sinusoïde en phase à la première fréquence et la deuxième sinusoïde d'entrée ;

dans lequel le générateur de signaux (400) est **caractérisé en ce qu'**il comprend en outre :

un premier réseau déphaseur (420A) couplé au premier mélangeur, le premier réseau déphaseur étant agencé pour recevoir une sortie du premier mélangeur et générer un premier signal déphasé ;

un deuxième réseau déphaseur (420B) couplé au deuxième mélangeur, le deuxième réseau déphaseur étant agencé pour recevoir une sortie du deuxième mélangeur et générer un deuxième signal déphasé ; et

un premier additionneur (422A) couplé aux premier et deuxième réseaux déphaseurs, le premier additionneur étant agencé pour recevoir et additionner l'opposé du premier signal déphasé et le deuxième signal déphasé pour générer un premier signal de sortie ;

dans lequel le premier signal de sortie comprend une première sinusoïde de sortie à une fréquence égale à la somme de la fréquence radio d'oscillateur local et de la fréquence intermédiaire d'oscillateur local, et dans lequel la composante de fréquence à une fréquence égale à la différence entre la fréquence intermédiaire d'oscillateur local et la fréquence radio d'oscillateur local est annulée dans le premier signal de sortie ;

dans lequel le premier réseau déphaseur (420A) est en outre agencé pour générer un troisième signal déphasé et le deuxième réseau déphaseur (420B) est en outre agencé pour générer un quatrième signal déphasé, et dans lequel le générateur (400) comprend en outre :

un deuxième additionneur (422B) couplé aux premier et deuxième réseaux déphaseurs, le deuxième additionneur étant agencé pour recevoir les troisième et quatrième signaux déphasés pour générer un deuxième signal de sortie et pour soustraire l'opposé du troisième signal déphasé au quatrième signal déphasé ;

dans lequel le deuxième signal de sortie comprend une deuxième sinusoïde de sortie à une fréquence égale à la somme de la fréquence radio d'oscillateur local et de la fréquence intermédiaire d'oscillateur local ;

dans lequel la composante de fréquence à une fréquence égale à la différence entre la fréquence radio d'oscillateur local et la fréquence intermédiaire d'oscillateur local est annulée dans le deuxième signal de sortie ;

dans lequel le troisième signal déphasé est décalé d'environ quatre-vingt-dix degrés par rapport au premier signal déphasé ;

le deuxième signal déphasé est décalé d'environ quatre-vingt-dix degrés par rapport au quatrième signal déphasé ; et

dans lequel les première et deuxième sinusoïdes de sortie sont en quadrature.

10. Procédé pour générer des sinusoïdes d'oscillateur local pour une élévation directe en fréquence vers une fréquence d'émission d'un dispositif de communication sans fil (100), le procédé comprenant les étapes suivantes :

mélanger une première sinusoïde en quadrature à une première fréquence avec une deuxième sinusoïde d'entrée à une deuxième fréquence pour générer un premier signal mélangé, la première fréquence étant une fréquence intermédiaire d'oscillateur local du dispositif de communication sans fil, la deuxième fréquence étant une fréquence radio d'oscillateur local du dispositif de communication sans fil ;

mélanger une première sinusoïde en phase à la première fréquence avec la deuxième sinusoïde d'entrée pour générer un deuxième signal mélangé ;

déphaser le premier signal mélangé pour générer un premier signal en phase et un premier signal en quadrature ;

déphaser le deuxième signal mélangé pour générer un deuxième signal en phase et un deuxième signal en quadrature ; et

combiner le premier signal en phase et le deuxième signal en quadrature pour générer un premier signal de sortie, le premier signal de sortie comprenant une première sinusoïde de sortie à une fréquence égale à la somme de la fréquence radio d'oscillateur local et de la fréquence intermédiaire d'oscillateur local, et la composante de fréquence à une fréquence égale à la différence entre la fréquence intermédiaire d'oscillateur local et la fréquence radio d'oscillateur local étant annulée dans le premier signal de sortie, et la fréquence d'émission étant égale à la somme de la fréquence radio d'oscillateur local et de la fréquence intermédiaire d'oscillateur local ;

combiner le premier signal en quadrature et le deuxième signal en phase pour générer un deuxième signal de sortie ;

dans lequel le deuxième signal de sortie comprend une deuxième sinusoïde de sortie à une fréquence égale à la somme de la fréquence radio d'oscillateur local et de la fréquence intermédiaire d'oscillateur local ;

et dans lequel la composante de fréquence à une fréquence égale à la différence entre la fréquence radio d'oscillateur local et la fréquence intermédiaire d'oscillateur local est annulée dans le deuxième signal de sortie ; et

dans lequel les première et deuxième sinusoïdes de sortie sont en quadrature.

11. Modulateur comprenant :

un générateur de signaux selon la revendication 1 ou la revendication 9 ; et

un élévateur de fréquence direct (230) agencé pour recevoir et mélanger au moins un signal analogique et le premier signal de sortie pour fournir un signal modulé.

12. Émetteur dans un téléphone cellulaire comprenant :

le générateur de signaux selon la revendication 1 ou la revendication 9 ;

au moins un tampon d'amplification (222) agencé pour recevoir au moins un signal analogique et pour fournir ledit au moins un signal analogique amplifié ;

un élévateur de fréquence direct (230) couplé fonctionnellement audit au moins un tampon d'amplification, l'élévateur de fréquence étant agencé pour recevoir et mélanger ledit au moins un signal analogique amplifié et le premier signal de sortie pour fournir un signal modulé ;

au moins un amplificateur à gain variable (VGA 250) couplé fonctionnellement à l'élévateur de fréquence direct, le VGA étant agencé pour recevoir et amplifier le signal modulé.

FIG. 1

FIG. 2

EP 1 362 412 B1

FIG. 3

FIG. 4

FIG. 5

FIG. 6A

600B

I<sub>OUT</sub>+      Q<sub>OUT</sub>+      I<sub>OUT</sub>-      Q<sub>OUT</sub>-

FIG. 6B

IN+                                          IN-

FIG. 6C

FIG. 6D

FIG. 7

EP 1 362 412 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5412351 A
- US 6029059 A

- US 86209497 A